# EUROPÄISCHE PATENTSCHRIFT

(11) **EP 2 640 866 B1**
(45) Veröffentlichungstag und Bekanntmachung des Hinweises auf die Patenterteilung: **30.09.2020**
(21) Anmeldenummer: 11791494.5
(22) Anmeldetag: 17.11.2011
(51) Int. Cl.: C23C 16/22, C23C 16/30, C23C 16/452, C23C 16/455, B29C 65/00, B05D 1/00, C09J 5/02, H01J 37/32, B05D 3/04, B29C 65/02

(54) **VERFAHREN ZUM VERBINDEN VON SUBSTRATEN UND DAMIT ERHÄLTLICHE VERBUNDSTRUKTUR**
METHOD FOR CONNECTING SUBSTRATES, AND COMPOSITE STRUCTURE OBTAINABLE THEREBY
PROCÉDÉ DE LIAISON DE SUBSTRATS ET STRUCTURE COMPOSITE POUVANT ÊTRE OBTENUE GRÂCE AUDIT PROCÉDÉ

(30) Priorität: 18.11.2010 DE 102010044114
(43) Veröffentlichungstag der Anmeldung: 25.09.2013
(73) Patentinhaber: Fraunhofer-Gesellschaft zur Förderung der angewandten Forschung e.V., 80686 München (DE)
(72) Erfinder: WILKEN, Ralph, 26180 Rastede (DE); IHDE, Jörg, 28865 Lilienthal (DE); REGULA, Christoph, 28213 Bremen (DE)
(74) Vertreter: Hoffmann Eitle
(86) Internationale Anmeldenummer: PCT/EP2011/070387
(87) Internationale Veröffentlichungsnummer: WO 2012/066096

(56) Entgegenhaltungen:
- WO-A1-2008/090701
- WO-A1-2008/090701
- DE-A1-102005 042 109
- DE-A1-102005 059 706
- DE-A1-102006 044 347
- US-A1- 2010 193 120
- PIHAN S A ET AL: "Plasma polymerized hexamethyl disiloxane in adhesion applications", SURFACE AND COATINGS TECHNOLOGY, ELSEVIER, AMSTERDAM, NL, Bd. 203, Nr. 13, 25. März 2009 (2009-03-25), Seiten 1856-1862, XP025993970, ISSN: 0257-8972, DOI: 10.1016/J.SURFCOAT.2009.01.026 [gefunden am 2009-01-24]
- Munish Gupta: "LOW-PRESSURE AND ATMOSPHERIC PRESSURE PLASMA POLYMERIZED SILICA-LIKE FILMS AS PRIMERS FOR ADHESIVE BONDING OF ALUMINUM", , 1. Januar 2007 (2007-01-01), Seiten 1-215, XP55016518, Gefunden im Internet: URL:http://etd.ohiolink.edu/send-pdf.cgi/G UPTA MUNISH.pdf?ucin1187019889 [gefunden am 2012-01-13]
- PHILIPP BRINGMANN ET AL: "Atmospheric Pressure Plasma Deposition of Adhesion Promotion Layers on Aluminium", PLASMA PROCESSES AND POLYMERS, Bd. 6, Nr. S1, 1. Juni 2009 (2009-06-01), Seiten S496-S502, XP55016509, ISSN: 1612-8850, DOI: 10.1002/ppap.200931105

## Beschreibung

### GEBIET DER ERFINDUNG

Die vorliegende Erfindung betrifft Verfahren zum Verbinden von Substraten, eine mit den Verfahren erhältliche Verbundstruktur, sowie Verfahren zur Herstellung einer Verbundstruktur. Das erfindungsgemäße Verfahren beruht auf dem überraschenden Befund, dass mittels eines Atmosphärendruckplasmastrahls abgeschiedene Plasmapolymerschichten eine, vorzugsweise stoffschlüssige, Verbindung von Substraten, beispielsweise von Fügeteilen oder Partikeln, ermöglichen, indem die Plasmapolymerschichten lediglich in Kontakt miteinander gebracht werden. Es ist hierzu kein weiterer Hilfsstoff, insbesondere kein Klebstoff erforderlich.

### STAND DER TECHNIK

Plasmaverfahren zur Vorbehandlung von Substraten sind bekannt. In der DE 44 07 478 88 werden Faserverbundkunststoffe mit polymeren Oberflächen einer Niederdruckplasmabehandlung unterzogen, bevor der Klebstoff aufgetragen wird. Die EP 0 761 415 A2 betrifft ein Verfahren zur Oberflächenvorbehandlung von Werkstücken durch Überstreichen der Oberfläche mit einem Plasmastrahl. Hierduch soll die Oberfläche so verändert werden, dass sie mit Flüssigkeiten, wie Klebstoffen und Lacken benetzt werden kann. Derartige Vorbehandlungen von Substraten im Plasma sind insbesondere bei Materialien interessant, die schlechte adhäsive Eigenschaften besitzen. Solche Materialien sind beispielsweise Polyolefine (PP, PE), fluororganische Polymere (PTFE, ETFE, PVDF), Silicone, etc.

Die WO 01/32949 A1 beschäftigt sich mit Atmosphärendruck-Plasmaverfahren zur Beschichtung von Oberflächen. Dabei wird mit Hilfe eines Plasmas ein Vorläufermaterial zur Reaktion gebracht und das Reaktionsprodukt auf der Oberfläche abgeschieden. Derartigen Beschichtungen, die unter Verwendung von Hexamethyldisiloxan, Tetraethoxysilan oder Propan als Precursorgas erhalten wurden, wird eine gute Haftung zum Untergrund und Stabilität gegenüber alkoholischen Lösungsmitteln zugeschrieben.

Plasmapolymere Haftschichten sind in der WO 2004/035857 A2 beschrieben. Zur Erzeugung solcher Haftschichten wird das im Plasmazustand befindliche Vorläufermaterial so auf dem Substrat abgeschieden, dass zumindest ein Teil seiner Doppel- und/oder Dreifachbindungen erhalten bleibt. Derartige Plasmapolymerschichten erlauben beispielsweise die Aufvulkanisation von EPDM. Dabei reagieren die Doppelbindungen der Haftvermittlerschicht über das Vulkanisationsmittel mit dem EPDM. Die Verbindung der plasmapolymeren Haftschicht mit dem EPDM erfolgt somit über ein zusätzliches Agens.

Die WO 00/78469 A2 betrifft ein Verfahren zum Aufbringen einer Beschichtung, die reaktive Epoxygruppen enthält, auf einem Substrat. In dem Verfahren wird das Substrat in Gegenwart bestimmter Epoxyverbindungen einer Plasmaentladung ausgesetzt. Um mit dieser Beschichtung zwei Substrate zu verbinden, ist ein zusätzliches Kupplungsmittel, wie beispielsweise Diamine, erforderlich, denn die Epoxyverbindungen können untereinander nicht reagieren.

In dem Verfahren der DE 42 42 059 C1 werden Kunststoff-Formkörper mit weiteren Kunststoffkomponenten dadurch verbunden, dass durch Plasmapolymerisation eine Zwischenschicht auf zumindest eine der Fügeflächen aufgebracht wird und anschließend unter Wärmezufuhr eine flächige Verschweißung oder Schmelzverklebung erfolgt. Die Plasmapolymerisation erfolgt dabei im Niederdruckplasma.

Die japanischen Patentanmeldungen JP-A-2009027120, JP-A-2009028920 und JP-A-2009028923 betreffen ebenso Verfahren zum Verbinden von Materialien in Gegenwart von Plasmapolymerschichten. Nach der Lehre der JP-A-2009028920 kommt zum Abscheiden der Plasmapolymerschichten eine Niederdruckplasmaapparatur zum Einsatz, wie sie in Fig. 1 der Druckschrift illustriert ist.

Ein weiteres Dokument, in dem die Abscheidung von Plasmapolymerschichten im Niederdruckplasma beschrieben wird, ist die US 2010/0193120 A1. Nach Aktivierung durch die Zufuhr von Energie, vorzugsweise durch die Bestrahlung mit UV-Licht, kann eine solche auf einem ersten Bauteil abgeschiedene Plasmapolymerschicht stoffschlüssig mit einem zweiten Bauteil verbunden werden.

Angesichts des oben beschriebenen Standes der Technik haben sich die Erfinder die Aufgabe gestellt, ein besonders einfaches Verfahren zum, vorzugsweise stoffschlüssigen, Verbinden von Substraten zur Verfügung zu stellen, das ohne weitere Hilfsstoffe, insbesondere ohne Klebstoffe, auskommt.

### ZUSAMMENFASSUNG DER ERFINDUNG

Diese Aufgabe wird erfindungsgemäß durch ein Verfahren zum Verbinden von Substraten gelöst, wie es in den nebengeordneten Patentansprüchen 1 und 3 spezifiziert ist. Das Verfahren ist dadurch gekennzeichnet, dass in einem ersten Schritt Plasmapolymerschichten mittels eines Atmosphärendruckplasmas auf mindestens einem der zu verbindenden Substrate abgeschieden werden. Patentanspruch 1 betrifft dabei die Variante des Verfahrens, bei dem beide Substrate, die verbunden werden sollen, mit einer Plasmapolymerschicht versehen sind. Die Variante, bei der nur eines der Substrate mit der Plasmapolymerschicht versehen wird und zur Verbindung mit einem zweiten Substrat in Kontakt gebracht wird, dessen Oberfläche mit der dieser Schicht reagieren kann, ist Gegenstand des Patentanspruchs 3.

Wie die Erfinder überraschend festgestellt haben, weisen Plasmapolymerschichten nach der Abscheidung mittels eines Atmosphärendruckplasmas eine derart hohe Restreaktivität auf, dass es beim bloßen In-Kontakt-Bringen mit geeigneten zweiten Substraten zur chemischen Reaktion zwischen den Fügepartnern kommt, so dass diese miteinander verbunden werden. Dabei sind solche Substrate "geeignet", die beide mit Plasmapolymerschichten versehen sind, die miteinander chemisch reagieren können. Alternativ kann auch nur ein Substrat mit einer Plasmapolymerschicht versehen sein, vorausgesetzt die Oberfläche des zweiten Substrats ist so beschaffen, dass sie mit der Plasmapolymerschicht des ersten Substrats reagieren kann. Ferner ist die Plasmapolymerschicht unmittelbar nach dem Abscheiden im Schritt (i) bereits in einem Maße vernetzt, dass es beim In-Kontakt-Bringen, beispielsweise durch Aufeinanderpressen der Substrate, nicht zur Verdrängung des Plasmapolymers kommt.

Bevorzugte Ausgestaltungen des erfindungsgemäßen Verfahrens sind Gegenstand der abhängigen Patentansprüche 2 und 4 bis 13. Gemäß einer weiteren bevorzugten Ausgestaltung des erfindungsgemäßen Verfahrens weisen die Plasmapolymerschichten an ihrer Oberfläche reaktive Stellen auf, die vorzugsweise ausgewählt sind aus Radikalstellen und Alkohol-, Amin-, Carbonyl-, Carboxyl-, Silanol-, SiH- und C=C-Gruppen und Kombinationen davon, und besonders bevorzugt Silanolgruppen sind.

Gemäß einem weiteren Aspekt betrifft die vorliegende Erfindung eine Verbundstruktur, die ein erstes und ein zweites Substrat umfasst. In der Verbundstruktur sind die Substrate über eine siliciumorganische Plasmapolymerschicht verbunden, die mit dem erfindungsgemäßen Verfahren gemäß Anspruch 12 erhältlich ist.

Gemäß einem weiteren Aspekt betrifft die vorliegende Erfindung ein Verfahren zur Herstellung einer Verbundstruktur, die ein erstes und ein zweites Substrat erfasst, wobei die Substrate über eine Plasmapolymerschicht miteinander verbunden sind und das Verfahren ein erfindungsgemäßes Verfahren zum Verbinden von Substraten umfasst.

### KURZE BESCHREIBUNG DER ZEICHNUNGEN

Fig. 1 zeigt das In-Kontakt-Bringen zweier Fügeteile, auf denen jeweils eine Plasmapolymerschicht abgeschieden ist, und die damit erhältliche Verbundstruktur.
Fig. 2 veranschaulicht eine Ausgestaltung des erfindungsgemäßen Verfahrens, bei dem es sich bei den Substraten um Partikel, insbesondere Metallpartikel, handelt, die jeweils mit Plasmapolymerschichten versehen sind.
Fig. 3 veranschaulicht die Abscheidung einer Plasmapolymerschicht in Schritt (i), indem Vorläuferverbindungen dieser Schicht in den relaxierenden Bereich des Atmosphärendruckplasmastrahls eingespeist werden.
Fig. 4 zeigt IR-Spektren von im Atmosphärendruckplasma abgeschiedenen Plasmapolymerschichten vor (Fig. 4a) und nach (Fig. 4b) der Temperung.
Fig. 5 zeigt IR-Spektren von im Niederdruckplasma abgeschiedenen Plasmapolymerschichten vor (Fig. 5a) und nach (Fig. 5b) der Temperung.

### AUSFÜHRLICHE BESCHREIBUNG DER ERFINDUNG

In beiden Varianten des erfindungsgemäßen Verfahrens wird eine Plasmapolymerschicht mittels eines Atmosphärendruckplasmas auf einem Substrat abgeschieden. Demnach erfolgt die Bildung der Plasmapolymere der Schicht aus Vorläuferverbindungen durch die Wirkung eines Atmosphärendruckplasmas. Unter einem "Atmosphärendruckplasma", auch als AD-Plasma oder Normaldruckplasma bezeichnet, versteht man ein Plasma, bei welchem der Druck ungefähr dem Atmosphärendruck entspricht. C. Tendero et al. geben in "Atmospheric pressure plasmas: A review"; Spectrochimica Acta Part B: Atomic Spectroscopy; 2005 einen Überblick über Atmosphärendruckplasmen. Die im erfindungsgemäßen Verfahren verwendbaren Atmosphärendruckplasmen können durch verschiedene Arten der Anregung erzeugt werden. In Frage kommen hier die AC (alternating current, Wechselstrom)-Anregung, die DC- (direct current, Gleichstrom) und Niederfrequenzanregung, die RF-Anregung und die Mikrowellenanregung, auch in gepulster Form. Vorzugsweise wird das erfindungsgemäß eingesetzte Atmosphärendruckplasma durch gepulste Hochfrequenzanregung erzeugt. Die Pulsfrequenz ist dabei nicht besonders beschränkt und kann 5 bis 100 kHz sein, wobei der Bereich von 10 bis 50 kHz bevorzugt ist.

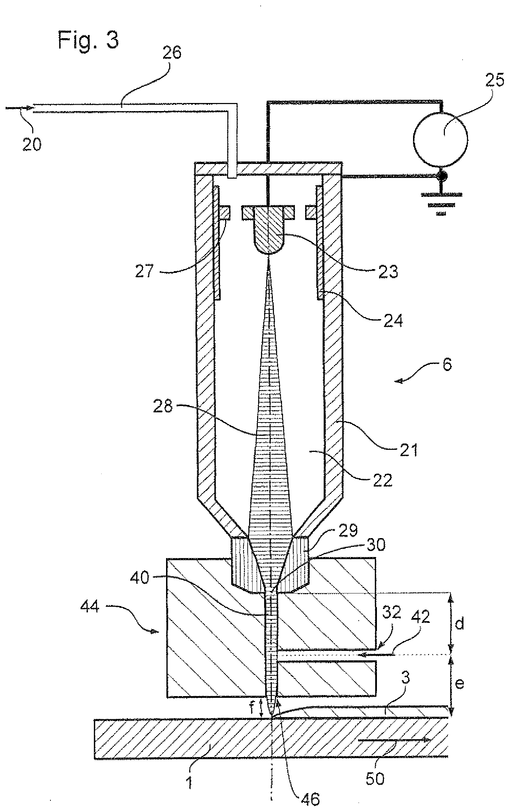

Aufgrund der einfachen Handhabung wird das Atmosphärendruckplasma im erfindungsgemäßen Verfahren vorteilhaft mit einer Plasmadüse erzeugt. Der grundsätzliche Aufbau einer Plasmadüse wird im Folgenden unter Bezugnahme auf Fig. 3 näher erläutert. Die Plasmadüse 6 weist ein elektrisch leitfähiges Gehäuse 21 auf, das vorzugsweise länglich, insbesondere rohrförmig ausgebildet ist. Das Gehäuse bildet einen von einem Prozessgas durchströmten Düsenkanal 22. In dem Düsenkanal ist, vorzugsweise koaxial, eine Elektrode 23 angeordnet. Ein Rohr 24 eines dielektrischen Materials, beispielsweise ein Keramikrohr, ist in den Düsenkanal 22 eingesetzt. Mittels eines Hochfrequenzgenerators 25 wird eine Spannung zwischen der Elektrode und dem Gehäuse angelegt. Das Prozessgas 20 wird durch eine Leitung 26 in den Düsenkanal eingeleitet, und zwar vorzugsweise so, dass es drallförmig durch den Kanal hindurchströmt. Diese Strömung des Prozessgases kann durch eine Dralleinrichtung 27 erreicht werden. Dabei kann es sich um eine Platte mit Löchern handeln. Prozessgase, die beispielsweise in Plasmadüsen verwendet werden können, sind zum Beispiel Stickstoff, Sauerstoff, Wasserstoff, Edelgase (insbesondere Argon), Ammoniak (NH₃), Schwefelwasserstoff (H₂S) und Mischungen davon, insbesondere Druckluft, Stickstoff-Wasserstoff-Gemische und Edelgas-Wasserstoff-Gemische.

Beim Betrieb der Atmosphärendruckplasmadüse verläuft die lichtbogenähnliche Plasmaentladung 28 von der Spitze der Mittelelektrode 23 im Wesentlichen in Axialrichtung des Düsenkanals 22 zu der Gegenelektrode 29, die ebenso wie das Gehäuse 21 geerdet ist. Hierdurch tritt ein Plasmastrahl 40 unmittelbar unterhalb des Düsenausgangs 30 aus.

Die Funktionsweise einer Plasmadüse ist dem Fachmann geläufig und ist beispielsweise in der DE-A-195 32 412, sowie der DE-U-299 21 694 beschrieben. Im Ergebnis wird beim Betrieb der Plasmadüse unterhalb der Düsenöffnung ein Plasmastrahl in Form einer "Flamme" erzeugt. Grundsätzlich können im erfindungsgemäßen Verfahren beliebige Plasmadüsen eingesetzt werden. Gemäß einer bevorzugten Ausführungsform kommen Plasmadüsen zum Einsatz, wie sie in der DE-A-195 32 412 oder DE-U-299 21 684 beschrieben sind. Besonders bevorzugt kommen Plasmadüsen zum Einsatz, die von der DE-A-195 32 412 umfasst sind, insbesondere kommerziell erhältliche Standard-Einzeldüsen der Firma Plasmatreat (Deutschland).

Wie die Erfinder überraschenderweise gefunden haben, weisen die im Atmosphärendruckplasma, insbesondere mit einer Plasmadüse, abgeschiedenen Plasmapolymerschichten, ganz besonders solche, zu deren Abscheidung in Schritt (i) Vorläuferverbindungen der Plasmapolymerschicht(en) in den Bereich des relaxierenden Plasmas des mit einer Plasmadüse erzeugten Atmosphärendruckplasmastrahls eingespeist werden, eine derart hohe Restreaktivität auf, dass sie ohne weitere Hilfsmittel, wie beispielsweise Klebstoff, mit einer zweiten solchen Plasmapolymerschicht (im Verfahren gemäß Patentanspruch 1) bzw. einem zweiten Substrat, dessen Oberfläche mit der Plasmapolymerschicht reagieren kann (im Verfahren gemäß Patentanspruch 2) stoffschlüssig verbunden werden können. Es konnte experimentell gezeigt werden, dass dies bei Plasmapolymerschichten, die im Niederdruckplasma abgeschieden werden, nicht möglich ist.

Die überraschenden Befunde, die der vorliegenden Erfindung zu Grunde liegen, erklären sich die Erfinder dadurch, dass die Schichtabscheiderate bei Atmosphärendruck bis zu einem Faktor 1000 höher ist als im Niederdruckplasma. Daher haben die reaktiven Stellen vermutlich deutlich weniger Zeit, innerhalb der Plasmapolymerschicht miteinander zu reagieren. Hinzu kommt - so kann angenommen werden - der deutlich höhere Energieeintrag des Plasmas bei Niederdruck auf abgeschiedene Schichten, der zu einem Abreagieren reaktiver Stellen führt, vergleichbar mit einem Abreagieren beim starken Tempern.

Die Vorläuferverbindungen der Plasmapolymerschicht können zusammen mit dem Prozessgas 20 zugeführt werden. Dann kommt es bereits in dem "aktiven" Plasma zur Plasmapolymerisation. Unter einem "aktiven" Plasma wird allgemein ein Plasma verstanden, das sich innerhalb des Volumens befindet, welches von den Elektroden begrenzt ist. Im Falle der Fig. 3 befindet sich das aktive Plasma 28 innerhalb der Plasmadüse 6. Hingegen befindet sich bei einem "relaxierenden" Plasma (es wird gelegentlich auch als "After-Glow"-Plasma bezeichnet), das in dieser Patentanmeldung manchmal auch relaxierender Bereich des (Atmosphärendruck)Plasmas genannt wird, das Plasma außerhalb der Anregungszone, die durch die Elektroden begrenzt ist. Folglich befindet sich in Fig. 3 der Bereich des relaxierenden Plasmas, also der relaxierende Bereich des Plasmastrahls 40, zwischen dem Düsenausgang 30 und dem Substrat 1.

Gemäß einer bevorzugten Ausführungsform des erfindungsgemäßen Verfahrens werden in Schritt (i) Vorläuferverbindungen der Plasmapolymerschicht in den Bereich des relaxierenden Plasmas eingespeist. Dies ist in Fig. 3 veranschaulicht. Eine Zuführung der Vorläuferverbindungen mit dem Prozessgas ist weniger vorteilhaft, da es hierbei zu einer Vorreaktion, beispielsweise Vorpolymerisation der Vorläuferverbindungen bereits im Bereich des aktiven Plasmas 28 kommen kann.

Wie in Fig. 3 gezeigt ist, erfolgt die Einspeisung der Vorläuferverbindungen der Plasmapolymerschicht in Schritt (i) in den Bereich des relaxierenden Plasmas 40 vorteilhaft mit Hilfe eines Adapters 44, der auf die Plasmadüse 6 aufgesetzt ist. Der Adapter 44 weist einen Kanal auf, durch den der relaxierende Plasmastrahl 40 hindurchgeführt wird. Über eine Durchbrechung 32 des Adapters werden Vorläuferverbindungen der Plasmapolymerschicht in den relaxierenden Bereich des Atmosphärendruckplasmastrahls 40 eingespeist. Die Strömungsrichtung der Vorläuferverbindungen ist in Fig. 3 durch den Pfeil 42 dargestellt. Durch die Verwendung eines solchen Adapters 44 lässt sich eine besonders kontrollierte Abscheidung der Plasmapolymerschichten erreichen. Die Ursache dafür liegt beispielsweise darin, dass der Einsatz eines solchen Adapters verhindert, dass Luftsauerstoff in den relaxierenden Bereich 40 des Plasmastrahls gelangt. Aus diesem Grunde wird auch der Abstand zwischen dem Austrittsende des Führungskanals 46 und der Oberfläche des zu beschichtenden Substrats 1 möglichst klein gewählt. So ist der Druck zwischen dem Austrittsende 46 und der Substratoberfläche größer als der Umgebungsdruck, wodurch verhindert wird, dass Luftsauerstoff aus der Umgebung im Bereich der Abscheidung der Plasmapolymerschicht 3 unkontrolliert an den Plasmastrahl 40 gelangen kann. Der entsprechende Abstand, der in Fig. 3 mit dem Bezugszeichen f versehen ist, ist bevorzugt zwischen 15 mm und 2 mm, mehr bevorzugt zwischen 10 mm und 4 mm und noch mehr bevorzugt etwa 6 mm. Solche Adapter sind beispielsweise in der DE 10 2005 059 706 A1 beschrieben. Erfindungsgemäß verwendbare Adapter 44 können z.B. aus Aluminium gefertigt sein.

Die Form, in der die Vorläuferverbindungen in das Atmosphärendruckplasma eingespeist werden, ist nicht besonders beschränkt. Je nach Art der Vorläuferverbindung kommt ihre Einspeisung im gasförmigen, flüssigen oder festen, pulverförmigen Zustand in Frage. Ggf. erfolgt der Transport der Beschichtungsvorläuferverbindung mit Hilfe eines Trägergases. HMDSO, TEOS und HMDSN können beispielsweise als Gas zugeführt werden, das z.B. durch einen Verdampfer erzeugt wird (in Fig. 3 nicht dargestellt). Als Trägergase für die Zuführung der Vorläuferverbindungen können beispielsweise Stickstoff, Edelgase wie Argon und Helium, Mischungen solcher Edelgase mit Druckluft, Formiergas und Druckluft verwendet werden.

In dem Plasmastrahl 40 erfolgt die Plasmapolymerisation der Vorläuferverbindungen und eine Plasmapolymerschicht 3 scheidet sich auf dem Substrat 1 ab. Wie in Fig. 3 durch den Pfeil 50 symbolisiert ist, wird die Atmosphärendruckplasmadüse 6 zusammen mit dem Adapter 44 relativ zu dem Substrat 1 bewegt. Durch Überstreichen der gesamten Substratoberfläche kann auf diese Weise ein Substrat vollständig mit einer Plasmapolymerschicht versehen werden.

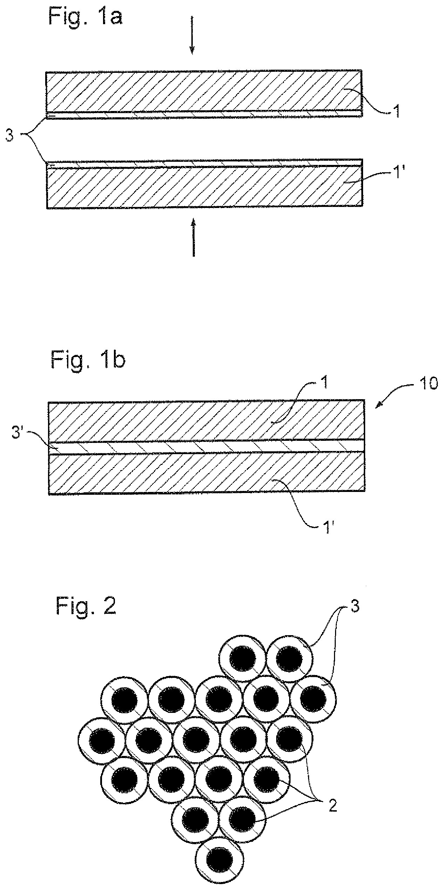

Bei den mit den erfindungsgemäßen Verfahren zu verbindenden Substraten kann es sich um Fügeteile handeln. Eine solche Ausführungsform ist in Fig. 1a veranschaulicht. Dabei werden ein erstes Substrat 1 und ein zweites Substrat 1', die jeweils mit einer Plasmapolymerschicht 3 versehen sind, in Kontakt gebracht. Dies ist durch die Pfeile veranschaulicht. Es kommt dabei zur Verbindung der Substrate unter Bildung einer Verbundstruktur 10, in der die beiden Substrate über eine Plasmapolymerschicht 3' verbunden sind (siehe Fig. 1b). In der Plasmapolymerschicht 3' sind die Plasmapolymerschichten 3 miteinander, vorzugsweise stoffschlüssig, verbunden. Unter "stoffschlüssigen" Verbindungen werden erfindungsgemäß Verbindungen verstanden, bei denen die Verbindungspartner durch atomare oder molekulare Kräfte zusammengehalten werden. Es handelt sich folglich insbesondere um nicht lösbare Verbindungen, die sich nur durch Zerstörung der Verbindungsmittel trennen lassen.

Bei den Substraten kann es sich ferner um Partikel, beispielsweise Metallpartikel, handeln. Eine solche Ausführungsform des erfindungsgemäßen Verfahrens, bei dem zahlreiche Partikel 2 mit Plasmapolymerschichten 3 versehen sind, ist in Fig. 2 illustriert. Solche Partikel 2, die mit Plasmapolymerschichten 3 versehen, insbesondere umhüllt, sind, können beispielsweise dadurch erhalten werden, dass die Partikel und Vorläuferverbindungen der Plasmapolymerschicht beide in das Atmosphärendruckplasma eingespeist werden, wo es zur Abscheidung von Plasmapolymerschichten auf den Partikeln kommt. Insbesondere werden dabei die Partikel 2 von der Plasmapolymerschicht 3 umhüllt. Ein solches Verfahren zum Beschichten von Partikeln, insbesondere Metallpartikeln, mit Plasmapolymerschichten ist beispielsweise in der DE 10 2005 042 109 A1 und der korrespondierenden WO 2007/028798 beschrieben. Beim In-Kontakt-Bringen der Plasmapolymerschichten in Fig. 2 kommt es zur Bildung einer Verbundstruktur, die Partikel 2, dispergiert in einer Matrix aus Plasmapolymer 3, enthält. Das In-Kontakt-Bringen erfolgt dabei besonders vorteilhaft durch Kompaktieren, beispielsweise in Pressen. Um die Verbindung der Partikel in der Verbundstruktur zu verstärken, erwies sich das Anlegen von Vakuum an das Presswerkzeug als geeignet.

Solche Verbundstrukturen lassen sich zu Bauteilen formen. Dies kann besonders einfach in entsprechend geformten Presswerkzeugen geschehen. Für elektrisch isolierende Plasmapolymere sind auf diese Weise elektrisch isolierende Bauteile hoher Wärmeleitfähigkeit zugänglich, wenn die Partikel aus Materialien mit hoher Wärmeleitfähigkeit bestehen. Mit Partikeln aus weichmagnetischen Materialien, wie beispielsweise Fe-Si-Legierungen, insbesondere solchen mit einem Si-Gehalt von etwa 6 Gew.-%, lassen sich weichmagnetische Bauteile herstellen, in denen Wirbelstromverluste minimiert sind.

Unter "In-Kontakt-Bringen" wird erfindungsgemäß verstanden, dass die zu verbindenden Oberflächen, also die Oberflächen der beiden Plasmapolymerschichten im Verfahren gemäß Patentanspruch 1 und die Oberfläche der Plasmapolymerschicht und die Oberfläche des zweiten Substrats im Verfahren gemäß Patentanspruch 3, sich in Schritt (ii) berühren, so dass es zu einer sogenannten Autoadhäsion kommen kann. Mithin werden die zu verbindenden Oberflächen in Schritt (ii) der erfindungsgemäßen Verfahren zum Verbinden von Substraten vorzugsweise in unmittelbarem Kontakt gebracht, in anderen Worten berühren sie sich unmittelbar. Entsprechend wird in den erfindungsgemäßen Verfahren zur Verbindung der Substrate außer den Plasmapolymerschichten kein Klebstoff eingesetzt. Beim In-Kontakt-Bringen der Plasmapolymerschicht(en) in Schritt (ii) kommt es erfindungsgemäß zu chemischen Reaktionen. Welche Reaktionen dabei konkret ablaufen, hängt von der chemischen Struktur der jeweiligen Plasmapolymerschicht(en), insbesondere den reaktiven Stellen an der Oberfläche ab. In dieser Anmeldung werden unter "reaktiven Stellen" der Plasmapolymerschicht solche Stellen verstanden, die beim In-Kontakt-Bringen in Schritt (ii), insbesondere durch chemische Reaktion zur Verbindung der Substrate führen. Als Reaktionen kommen beispielsweise Kondensationsreaktionen, Additionsreaktionen und Rekombinationen freier Radikale in Frage. Als Kondensationsreaktionen kommen solche zwischen Silanolgruppen und Alkoholen (also Silanol + Silanol, Alkohol + Silanol oder Alkohol + Alkohol), zwischen Alkohol und Carbonsäure (unter Esterbildung) und zwischen Amin und Carbonsäure (unter Amidbildung) in Frage. Als Additionsreaktionen lassen sich die Reaktionen zwischen SiH und ungesättigten Bindungen, wie C=C (Hydrosilylierung), Additionsreaktionen von Alkohol und Carbonyl sowie Amin und Carbonyl und [2 + 4]-Cycloadditionen nennen. Gemäß einer besonders bevorzugten Ausführungsform weisen die zu verbindenden Plasmapolymerschichten an der Oberfläche jeweils Silanolgruppen auf, die in Schritt (ii) durch Kondensationsreaktion Si-O-Si-Brücken bilden und so die Plasmapolymerschichten und damit auch die mit ihnen versehenen Substrate stoffschlüssig verbinden.

Zum Abscheiden der gewünschten Plasmapolymerschichten stehen geeignete Vorläuferverbindungen zur Verfügung. Zur Erzeugung von Plasmapolymerschichten, die typischerweise Silanolgruppen als reaktive Stellen aufweisen, die in Schritt (ii) des erfindungsgemäßen Verfahrens Kondensationsreaktionen eingehen können, kommen Tetraalkoxy(mono)silane, Tetraalkyl(mono)silane, Tetraacyloxy(mono)silane und peralkylierte Siloxane und Silazane, insbesondere Di-, Tri- und Tetrasiloxane (auch cyclische) und Disilazane in Frage.

Aufgrund der verbesserten Verdampfbarkeit und der damit verbundenen bequemen Zufuhr mit dem Trägergas handelt es sich bei den Alkyl- bzw. Alkoxygruppen in den oben genannten Verbindungen vorzugsweise um C₁₋₆-Alkyl bzw. C₁₋₆-Alkoxygruppen, mehr bevorzugt um Methyl, Ethyl oder Propyl bzw. Methoxy, Ethoxy oder Propoxy. Entsprechendes gilt für die Acyloxy-Gruppen. Auch hier handelt es sich vorzugsweise um eine C₁₋₆-Acyloxygruppe, wobei die Acetoxygruppe besonders bevorzugt ist. Im Folgenden sollen einige konkrete Beispiele für bevorzugte Vorläuferverbindungen gegeben werden: Tetramethoxysilan, Tetraethoxysilan (TEOS), Triethoxysilan, Trimethoxysilan, Hexamethyldisiloxan (HMDSO), Hexamethyldisilazan (HMDSN), Tetramethylsilan, Tetraacetoxysilan, Octamethyltrisiloxan, Octamethylcyclotetrasiloxan, Triethylsilan, Trimethylsilan und Diethylsilan. Im Falle der Tetraalkylsilane, beispielsweise des Tetramethylsilans, können die Silanolgruppen aus dem Sauerstoff des Prozessgases und von Spuren von Wasser stammen.

Darüber hinaus können zur Ausbildung siliciumorganischer Plasmapolymerschichten Siliciumverbindungen verwendet werden, die eine Si-H-Bindung aufweisen (Hydrosilane). In Frage kommen hier insbesondere Trialkyl(mono)silane, Trialkoxy(mono)silane, Dialkyl(mono)silane und Dialkoxy(mono)silane. Aufgrund der leichteren Verdampfbarkeit der Verbindungen sind auch hier als Alkyl- bzw. Alkoxygruppen C₁₋₆-Alkyl- bzw. C₁₋₆-Alkoxygruppen bevorzugt und mehr bevorzugt sind Methyl, Ethyl oder Propyl bzw. Methoxy, Ethoxy oder Propoxy. Konkrete Beispiele bevorzugter Hydrosilane sind die folgenden Verbindungen: Triethoxysilan, Triethylsilan, Trimethoxysilan, Trimethylsilan und Diethylsilan. Wie sich zeigte, können Plasmapolymerschichten, die aus Hydrosilanen, wie den oben beispielhaft genannten, erhalten werden, in dem Schritt (ii) Hydrosilylierungsreaktionen (SiH + ungesättigte Bindung, insbesondere C=C) sowie Reaktionen zwischen SiH und Radikalstellen eingehen. Die ungesättigten Bindungen (insbesondere C=C) und Radikalstellen für diese Reaktionen können in den Plasmapolymerschichten beispielsweise durch die Verwendung von ungesättigten Kohlenwasserstoffen, eingeschlossen Acetylen, als Vorläuferverbindungen erhalten werden.

Außer mit Acetylen können organische Plasmapolymerschichten beispielsweise auch mit Ethen, Propen, Toluol, Xylol, Allylamin und - bei guter Kapselung gegenüber Luftsauerstoff - auch Alkanen als Vorläuferverbindungen erhalten werden.

Gemäß einer bevorzugten Ausführungsform handelt es sich bei den Plasmapolymerschichten in den erfindungsgemäßen Verfahren zum Verbinden von Substraten und zur Herstellung einer Verbundstruktur um siliciumhaltige, insbesondere siliciumorganische Plasmapolymerschichten.

In einer Ausführungsform der Erfindung ist das Atmosphärendruckplasma ein Atmosphärendruckplasmastrahl, der mit einer Plasmadüse erzeugt wird, und als Prozessgas in der Plasmadüse wird ein stark oxidierendes Gas verwendet, beispielsweise Sauerstoff oder Luft (z. B. Druckluft). In dem Plasma kann durch das stark oxidierende Prozessgas die Struktur der zugeführten Vorläuferverbindungen zerstört und gleichzeitig erreicht werden, dass die abgeschiedenen Plasmapolymerschichten reaktive Stellen (z. B. funktionelle Gruppen) aufweisen, die in den Vorläuferverbindungen noch nicht vorlagen. Daher können auch nicht-reaktive Vorläuferverbindungen eingesetzt werden. Vorzugsweise werden Vorläuferverbindungen verwendet, die keine ungesättigten Kohlenstoff-Kohlenstoff (C-C)-Bindungen, insbesondere keine C=C-Bindungen aufweisen.

Besonders vorteilhaft sind die Plasmapolymerschichten auf dem ersten und zweiten Substrat gleichartig. Im Sinne der vorliegenden Anmeldung bedeutet in diesem Zusammenhang "gleichartig", dass die Plasmapolymerschichten unter Verwendung der gleichen Vorläuferverbindungen abgeschieden wurden und somit vorzugsweise den gleichen Typ reaktiver Stellen aufweisen. Im Falle gleichartiger Plasmapolymerschichten - beispielsweise weisen beide Schichten Silanolgruppen als reaktive Stellen auf - könnten chemische Reaktionen - beispielsweise Kondensationsreaktionen - theoretisch auch innerhalb der jeweiligen Plasmapolymerschicht, also vor dem In-Kontakt-Bringen der Plasmapolymerschichten erfolgen. Wie die Erfinder festgestellt haben, ist dies bei Plasmapolymeren aufgrund sterischer Hinderung kaum der Fall. Die an der Oberfläche befindlichen reaktiven Stellen finden innerhalb der Schicht häufig keinen Partner und daher kommt es überwiegend zur Reaktion zwischen den Schichten.

Um eine solche Reaktion innerhalb der jeweiligen Plasmapolymerschichten möglichst weitgehend zu unterbinden und somit die Reaktion zwischen den Schichten zu begünstigen, schließt sich der Schritt (ii) unmittelbar an den Schritt (i) an.

Um das Verbinden der Substrate durch das In-Kontakt-Bringen in Schritt (ii) zu begünstigen, erwiesen sich mehrere Maßnahmen als geeignet. Zunächst ist das Zusammenpressen der Substrate zu nennen. Der beim Zusammenpressen aufzuwendende Druck hängt von der Oberflächenbeschaffenheit, insbesondere der Rauhigkeit der zu verbindenden Oberflächen und auch von dem Verformungsverhalten der Substrate ab. Beispielsweise erwies sich ein Druck von mindestens 25 N/cm2 bei beschichteten Siliciumwafern als besonders geeignet. Ferner wird die Verbindung der Substrate begünstigt, wenn zwischen den zu verbindenden Schichten ein Vakuum angelegt wird. Die Evakuierung zwischen den zu fügenden Oberflächen gewährleistet einen guten Kontakt der beiden Fügeflächen. Wie bereits erläutert, ist das Anlegen von Vakuum auch dann vorteilhaft, wenn die Substrate Partikel sind, denn dies führt zu einer besseren Verbindung der Partikel innerhalb der Verbundstruktur. In der Praxis kann an die Kavität des Presswerkzeugs, in dem die mit einer Plasmapolymerschicht umhüllten Partikel zur Bildung der Verbundstruktur zusammengepresst werden (siehe Fig. 2), ein Vakuum angelegt werden.

Weiterhin erwies sich ein In-Kontakt-Bringen in Schritt (ii) bei erhöhter Temperatur als vorteilhaft, denn dadurch lässt sich beispielsweise die chemische Reaktion zwischen den Schichten begünstigen. Die Temperatur beträgt vorteilhaft mindestens 80°C. Die Maximaltemperatur, die in Schritt (ii) verwendet werden kann, hängt von der thermischen Stabilität der Plasmapolymerschicht und des Substrats ab. Um unnötige thermische Belastungen zu vermeiden, ist es bevorzugt, unterhalb der Glasübergangstemperatur des Plasmapolymers (T_{G}) zu arbeiten. Eine Maximaltemperatur unterhalb von T_{G} des Plasmapolymers in Schritt (ii) vermeidet, anders als beispielsweise die DE 42 42 059 C1, eine Erweichung des Plasmapolymers. Gemäß einer bevorzugten Ausführungsform wird Schritt (ii) bei einer Temperatur in einem Bereich von 80 °C bis (T_{G} - 10 °C) durchgeführt.

Die Dicke der Plasmapolymerschichten ist in der vorliegenden Erfindung nicht besonders beschränkt. Vorzugsweise liegt die Dicke im Bereich von 50 bis 1000 nm. Damit lässt sich erreichen, dass der etwaige Pressdruck beim Zusammenpressen besonders niedrig gewählt werden kann. Solche Schichtdicken liegen signifikant über denjenigen, die für Haftvermittlerschichten typisch sind. Letztere liegen üblicherweise im Bereich von 10 bis 20 nm. Indessen lässt sich das erfindungsgemäße Verfahren zum Verbinden von Substraten beispielsweise bei sehr glatten Substraten auch bei sehr dünnen Plasmapolymerschichten (beispielsweise mit einer Dicke von nur 5 nm) erfolgreich durchführen.

Gemäß einer weiteren Ausführungsform wird in dem erfindungsgemäßen Verfahren eine Plasmapolymerschicht in einem Atmosphärendruckplasma nur auf dem ersten Substrat abgeschieden und diese mit einem zweiten Substrat in Kontakt gebracht, dessen Oberfläche mit der Plasmapolymerschicht reagieren kann. Folglich weist die Oberfläche des zweiten Substrats an der Oberfläche reaktive Stellen auf, wie sie bereits für die Plasmapolymerschichten beschrieben wurden. Beispielsweise kann hier das zweite Substrat ein Glas-, Metall- oder Kunststoffsubstrat sein. Geeignete Kunststoffsubstrate sind beispielsweise solche aus Ethylen/Vinylalkohol- und Ethylen/Vinylacetat-Copolymeren, Polycarbonat (PC) und Polymethylmethacrylat (PMMA). Auch solche Kunststoffmaterialien, die von Natur aus keine reaktiven Stellen im Sinne der vorliegenden Erfindung aufweisen, können in dieser Ausführungsform des erfindungsgemäßen Verfahrens als Substrat verwendet werden, vorausgesetzt sie wurden einer entsprechenden Vorbehandlung unterzogen, um solche reaktiven Stellen an der Oberfläche zu erzeugen. Solche Vorbehandlungen sind beispielsweise die Teilfluorierung unter Anwesenheit von Sauerstoff, die nasschemische Behandlung (beispielsweise mit Schwefelsäure oder Beizen) oder die Plasmaaktivierung. Beispiele von Kunststoffen, die an sich inert sind und durch eine solche Vorbehandlung für das erfindungsgemäße Verfahren geeignet gemacht werden können, sind Polyethylen(PE), Polypropylen (PP)

Vorzugsweise weist das zweite Substrat - von Natur aus oder nach geeigneter Vorbehandlung - oberflächliche O- bzw. OH-Gruppen auf und kann somit im erfindungsgemäßen Verfahren mit der Plasmapolymerschicht auf dem ersten Substrat verbunden werden, wenn diese Schicht beispielsweise Silanolgruppen aufweist. Dann kommt es zur Verbindung der Substrate mittels Kondensationsreaktion. Beispielsweise besitzen Glassubstrate oberflächliche terminale O- bzw. OH-Gruppen, die mit der Plasmapolymerschicht des ersten Substrats durch Kondensation reagieren können.

Wie die Erfinder fesgestellt haben, ist der Anteil von OH-Gruppen in silanolhaltigen Plasmapolymerschichten, die in einem Atmosphärendruckplasma abgeschieden wurden, signifikant höher als in entsprechenden Plasmapolymerschichten, die unter Verwendung derselben Vorläuferverbindungen im Niederdruckplasma abgeschieden wurden. Aufgrund der zu geringen Dichte von OH-Gruppen erwiesen sich im Niederdruckplasma abgeschiedene silanolhaltige Plasmapolymerschichten als nicht geeignet zum Verbinden von Substraten.

Wie die Erfinder gefunden haben, sind zur Erzeugung einer Schicht mit möglichst vielen Silanolgruppen als reaktiven Stellen beim Einspeisen der Vorläuferverbindungen der Plasmapolymerschicht (beispielsweise HMDSO) in den Bereich des relaxierenden Plasmas des Atmosphärendruckplasmastrahls (Bezugszeichen 40 in Fig. 3) bestimmte Prozessparameter besonders geeignet:
(1) Zufuhrmenge an Vorläuferverbindung (z.B. HMDSO) von 30 bis 100 g/h;
(2) Abstand (in Fig. 3 mit dem Bezugszeichen e gekennzeichnet) zwischen dem Zufuhrkanal 32 und dem Substrat von 7 bis 16 mm;
(3) Sauerstoffgehalt des Prozessgases von 10 bis 30 %. Gemäß einer besonders bevorzugten Ausführungsform des erfindungsgemäßen Verfahrens sind alle obigen Prozessparameter (1) bis (3) gleichzeitig erfüllt.

Schließlich erwies sich eine Substrattemperatur beim Abscheiden der Plasmapolymerschicht in Schritt (i) zwischen 10 und 70°C als vorteilhaft.

### BEISPIELE

### Beispiel 1

Eine Plasmapolymerschicht auf Basis einer siliciumorganischen Vorläuferverbindung wurde in einer Dicke im Bereich von 400 nm mittels einer Atmosphärendruckplasmadüse mit aufgesetztem Adapter, wie sie in Fig. 3 schematisch gezeigt ist, auf die zu verklebenden Substrate (Siliciumwafer) appliziert. 50 g/h HMDSO als Vorläuferverbindung wurden mit 2 ℓ/min N₂-Trägergas in das After-Glow-Plasma eingespeist. Der Abstand zwischen der Zuleitung für das HMDSO-Trägergas-Gemisch und dem Düsenausgang (er ist in Fig. 3 mit dem Bezugszeichen d bezeichnet) betrug 7 mm, und der Abstand zwischen dieser Zuleitung und der Oberfläche des Substrats 1 (in Fig. 3 mit dem Bezugszeichen e bezeichnet) betrug ebenfalls 7 mm. Als Prozessgas wurde 29 ℓ/min Druckluft eingesetzt. Die Relativgeschwindigkeit zwischen Substrat und Plasmadüse betrug 20 m/min. Nach dem Abscheiden der Schichten wurden die Siliciumwafer direkt unter Druck (0,1 kN/cm²) und Hitze 120°C miteinander verpresst.

Es wurde eine stoffschlüssige Verbindung der beiden Wafer erhalten. Eine Schälbelastung dieses Verbunds führt zur Zerstörung der Siliciumwafer bzw. zum Kohäsionsbruch innerhalb der Beschichtungen. Ein adhäsives Versagen trat nicht auf.

### Beispiel 2

Eine Plasmapolymerschicht wurde mit dem Atmosphärendruck (AD) -Plasmasystem PFW 10 der Firma Plasmatreat (Hochfrequenzgenerator: FG5001) mit einem Adapter an dem Düsenausgang, wie er in Fig. 3 schematisch gezeigt ist, auf einem Siliciumwafer (bzw. goldbedampften Siliciumwafer zur IR-Analyse) abgeschieden. Zur Schichtbildung wurde das Plasma in der Düse mit Druckluft als Prozessgas erzeugt. Das Plasma wird dabei durch bogenähnliche Entladungen unter Anlegen einer Hochspannung mit der Frequenz zwischen 17 und 25 kHz generiert. In das so erzeugte Plasma wurde am Düsenausgang unter Verwendung von Stickstoff als Trägergas verdampftes Hexamethyldisiloxan (HMDSO) eingespeist.

Die Zusammensetzung der Plasmapolymerschicht wurde mittels Röntgen-Photoelektronenspektroskopie (XPS) ermittelt. Die Zusammensetzung war wie folgt:

| | |
|---|---|
| Si: | 28-26 Atom-% |
| O: | 51-48 Atom-% |
| C: | 21-26 Atom-% |

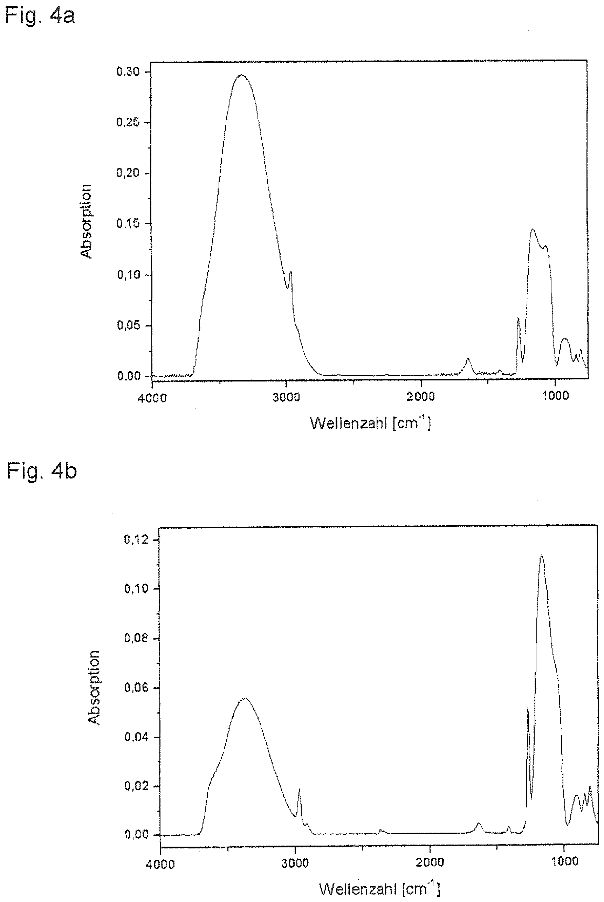

Vor der Temperung (Lagerung bei 100 °C für 30 min) wies die Schicht das IR-Spektrum auf, das in Fig. 4a gezeigt ist. Nach der Temperung (in der ganzen Fläche ohne Abdeckung durch Fügepartner) wurde das IR-Spektrum der Fig. 4b erhalten. Die Temperung ohne Abdeckung durch den Fügepartner, die die IR-Analyse vereiteln würde, soll vorliegend simulieren, was in Schritt (ii) des erfindungsgemäßen Verfahrens passiert.

Ein Vergleich der IR-Spektren der Figuren 4b und 4a zeigt eine Abnahme des "Wasseranteils" zwischen 2900-3600 cm⁻¹ und der Si-OH Bande bei etwa 950 cm⁻¹ zugunsten einer Nachreaktion der Si-O Bande im Bereich 1100-1200 cm⁻¹.

Die Siliciumsubstrate mit den abgeschiedenen Schichten (Dicke ca. 200 nm) wurden direkt nach der Herstellung mit dem Fügepartner (mit der gleichen Schicht versehen) unter Druck und 120 °C für 30 min gelagert. Danach erfolgte ein langsames Abkühlen bis zur Raumtemperatur unter gleichem Druck. Bei Schälbeanspruchung versagt der Verbund kohäsiv innerhalb der Plasmapolymerschicht. Gleiches Verhalten wurde beobachtet bei Pressungen für 1 h bei Raumtemperatur und für 30 min bei 80°C.

### Vergleichsbeispiel

Zum Vergleich wurden Plasmapolymerschichten im Niederdruckplasma abgeschieden und untersucht. Zur Abscheidung wurde eine zur Plasmapolymerisation geeignete Depositionskammer genutzt (siehe EP 1 432 529 B1 und DE 197 48 240 C2). Unter Einleitung der Prozessgase sowie der siliciumorganischen Vorläuferverbindungen (für diese Versuche HMDSO) wurde innerhalb der Prozesskammer durch Anregung ein Plasma zur Schichtabscheidung erzeugt. Durch die Anpassung der Prozessschritte wurde eine Schichtzusammensetzung hergestellt, die derjenigen ähnlich war, die in Beispiel 2 erhalten wurde. Die XPS-Analyse ergab die folgende Zusammensetzung:

| | |
|---|---|
| Si: | 26 Atom-% |
| O: | 43 Atom-% |
| C: | 31 Atom-% |

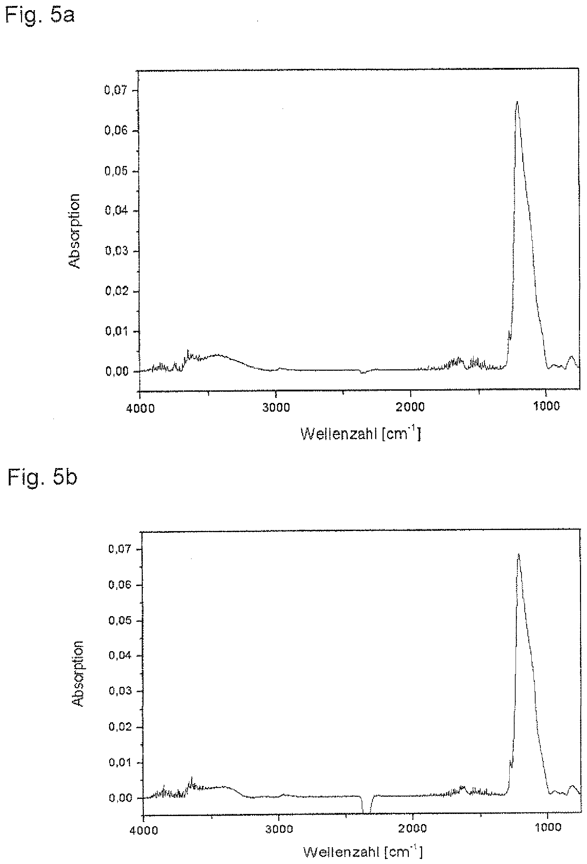

Direkt nach der Herstellung wurden die Proben wie in Beispiel 2 unter Druck und bei denselben Temperaturen (120 °C) für 30 min gelagert. Vor dem "Verpressen" ergab sich das in Fig. 5a gezeigte IR-Spektrum. Nach der Temperung ist das Spektrum nur sehr leicht verändert (Fig. 5b).

Mit den Schichten aus dem Niederdruckplasma lassen sich keine schlüssigen Flächenverbünde auf denselben Substratmaterialien herstellen. Die beschichteten Fügeteile fallen, nachdem die Proben abgekühlt sind und der Druck von den Fügeteilen genommen wurde, auseinander. Die Proben zeigen auch keine Veränderungen an den Oberflächen der Plasmapolymerschicht, die auf eine Verbindung der beiden Fügeteile hindeuten würden. Die beim AD-Plasma (siehe Beispiele 1 und 2) möglichen Reaktionen der Schicht, beispielsweise unter Druck und Wärmeeinfluss, lassen sich bei Schichten aus dem Niederdruckplasma nicht erzielen.

## Patentansprüche

1. Verfahren zum Verbinden von Substraten, das die folgenden Schritte umfasst:
(i) Abscheiden einer Plasmapolymerschicht jeweils auf einem ersten und einem zweiten Substrat mittels eines Atmosphärendruckplasmas; und
(ii) In-Kontakt-Bringen der Plasmapolymerschichten,
wobei in dem Verfahren zur Verbindung der Substrate außer den Plasmapolymerschichten kein Klebstoff eingesetzt wird und wobei sich der Schritt (ii) unmittelbar an den Schritt (i) anschließt.

2. Verfahren nach Anspruch 1, bei dem die Plasmapolymerschichten auf dem ersten und zweiten Substrat gleichartig sind.

3. Verfahren zum Verbinden von Substraten, das die folgenden Schritte umfasst:
(i) Abscheiden einer Plasmapolymerschicht auf einem ersten Substrat mittels eines Atmosphärendruckplasmas; und
(ii) In-Kontakt-Bringen der Plasmapolymerschicht mit einem zweiten Substrat, dessen Oberfläche mit der Plasmapolymerschicht reagieren kann,
wobei in dem Verfahren zur Verbindung der Substrate außer den Plasmapolymerschichten kein Klebstoff eingesetzt wird und wobei sich der Schritt (ii) unmittelbar an den Schritt (i) anschließt.

4. Verfahren nach Anspruch 3, bei dem das zweite Substrat ein Glas-, Metall- oder Kunststoffsubstrat ist.

5. Verfahren nach Ansprüchen 1 bis 4, bei dem Schritt (ii) bei einer Temperatur unterhalb der Glasübergangstemperatur des Plasmapolymers der Plasmapolymerschicht(en) erfolgt.

6. Verfahren nach Ansprüchen 1 bis 5, bei dem die Substrate Fügeteile sind.

7. Verfahren nach Ansprüchen 1 bis 5, bei dem die Substrate Partikel, insbesondere Metallpartikel, sind.

8. Verfahren nach Ansprüchen 1 bis 7, bei dem das Atmosphärendruckplasma ein Atmosphärendruckplasmastrahl ist, der mit einer Plasmadüse unter Verwendung eines Prozessgases erzeugt wird.

9. Verfahren nach Anspruch 8, bei dem zur Abscheidung der Plasmapolymerschicht in Schritt (i) Vorläuferverbindungen der Plasmapolymerschicht in den Bereich des relaxierenden Plasmas des Atmosphärendruckplasmastrahls eingespeist werden.

10. Verfahren nach Anspruch 9, bei dem im Atmosphärendruckplasma die Struktur der Vorläuferverbindungen zerstört wird.

11. Verfahren nach Anspruch 9 oder 10, bei dem die Vorläuferverbindungen keine ungesättigten C-C-Bindungen aufweisen.

12. Verfahren nach Ansprüchen 9 bis 11, bei dem die Vorläuferverbindungen ausgewählt sind aus Tetraalkylmonosilanen, Trialkylmonosilanen, Dialkylmonosilanen, Tetraalkoxymonosilanen, Trialkoxymonosilanen, Dialkoxymonosilanen, Tetraacyloxymonosilanen, peralkylierten Siloxanen und Silazanen.

13. Verfahren nach Ansprüchen 9 bis 12, bei dem als das Prozessgas ein stark oxidierendes Gas, vorzugsweise Sauerstoff oder Luft, verwendet wird.

14. Verbundstruktur, die ein erstes und ein zweites Substrat umfasst, die miteinander über eine siliciumorganische Plasmapolymerschicht verbunden sind, **dadurch gekennzeichnet, dass** die Verbundstruktur mit einem Verfahren nach Anspruch 12 erhältlich ist.

15. Verfahren zur Herstellung einer Verbundstruktur, die ein erstes und ein zweites Substrat umfasst, die miteinander über eine Plasmapolymerschicht verbunden sind, wobei das Verfahren ein Verfahren zum Verbinden von Substraten nach Ansprüchen 1 bis 13 umfasst.

## Claims

1. Method for connecting substrates, comprising the following steps:
(i) depositing one plasma polymer layer in each case on a first and a second substrate by means of an atmospheric-pressure plasma; and
(ii) bringing the plasma polymer layers into contact, wherein, in the method for connecting the substrates, no adhesive is used except for the plasma polymer layers and wherein step (ii) immediately follows step (i).

2. Method according to claim 1, wherein the plasma polymer layers on the first and second substrate are of the same kind.

3. Method for connecting substrates, comprising the following steps:
(i) depositing a plasma polymer layer on a first substrate by means of an atmospheric-pressure plasma; and
(ii) bringing the plasma polymer layer into contact with a second substrate, the surface of which can react with the plasma polymer layer,
wherein, in the method for connecting the substrates, no adhesive is used except for the plasma polymer layers and wherein step (ii) immediately follows step (i).

4. Method according to claim 3, wherein the second substrate is a glass, metal or plastics substrate.

5. Method according to claims 1 to 4, wherein step (ii) is carried out at a temperature below the glass transition temperature of the plasma polymer of the plasma polymer layer(s).

6. Method according to claims 1 to 5, wherein the substrates are adherends.

7. Method according to claims 1 to 5, wherein the substrates are particles, in particular metal particles.

8. Method according to claims 1 to 7, wherein the atmospheric-pressure plasma is an atmospheric-pressure plasma jet that is generated by means of a plasma nozzle using a process gas.

9. Method according to claim 8, wherein, for the deposition of the plasma polymer layer in step (i), precursor compounds of the plasma polymer layer are introduced into the region of the relaxing plasma of the atmospheric-pressure plasma jet.

10. Method according to claim 9, wherein the structure of the precursor compounds is destroyed in the atmospheric-pressure plasma.

11. Method according to claim 9 or 10, wherein the precursor compounds comprise no unsaturated C-C bonds.

12. Method according to claims 9 to 11, wherein the precursor compounds are selected from tetraalkylmonosilanes, trialkylmonosilanes, dialkylmonosilanes, tetraalkoxymonosilanes, trialkoxymonosilanes, dialkoxymonosilanes, tetraacyloxymonosilanes, peralkylated siloxanes and silazanes.

13. Method according to claims 9 to 12, wherein a strongly oxidising gas, preferably oxygen or air, is used as the process gas.

14. Composite structure comprising a first and a second substrate that are connected to one another via an organosilicon plasma polymer layer, **characterised in that** the composite structure can be obtained using a method according to claim 12.

15. Method for producing a composite structure that comprises a first and a second substrate that are connected to one another via a plasma polymer layer, wherein the method comprises a method for connecting substrates according to claims 1 to 13.

## Revendications

1. Procédé de liaison de substrats qui comprend les étapes suivantes :
(i) dépôt d'une couche de polymère plasma respectivement sur un premier et un second substrat au moyen d'un plasma à pression atmosphérique ; et
(ii) mise en contact des couches de polymère plasma,
dans lequel aucune colle n'est utilisée dans le procédé de liaison des substrats autre que les couches de polymère plasma et dans lequel l'étape (ii) suit immédiatement l'étape (i).

2. Procédé selon la revendication 1, dans lequel les couches de polymère plasma sur le premier et le second substrat sont identiques.

3. Procédé de liaison de substrats qui comprend les étapes suivantes :
(i) dépôt d'une couche de polymère plasma sur un premier substrat au moyen d'un plasma à pression atmosphérique ; et
(ii) mise en contact de la couche de polymère plasma avec un second substrat dont la surface est capable de réagir avec la couche de polymère plasma,
dans lequel aucune colle n'est utilisée dans le procédé de liaison des substrats autre que les couches de polymère plasma et dans lequel l'étape (ii) suit immédiatement l'étape (i).

4. Procédé selon la revendication 3, dans lequel le second substrat est un substrat en verre, en métal ou en plastique.

5. Procédé selon les revendications 1 à 4, dans lequel l'étape (ii) a lieu à une température inférieure à la température de transition vitreuse du polymère de plasma de la ou des couches de polymère plasma.

6. Procédé selon les revendications 1 à 5, dans lequel les substrats sont des pièces d'assemblage.

7. Procédé selon les revendications 1 à 5, dans lequel les substrats sont des particules, en particulier des particules métalliques.

8. Procédé selon les revendications 1 à 7, dans lequel le plasma à pression atmosphérique est un jet de plasma à pression atmosphérique qui est généré avec une buse à plasma en utilisant un gaz de procédé.

9. Procédé selon la revendication 8, dans lequel, pour le dépôt de la couche de polymère plasma à l'étape (i), des composés précurseurs de la couche de polymère plasma sont introduits dans la zone du plasma en relaxation du jet de plasma à pression atmosphérique.

10. Procédé selon la revendication 9, dans lequel la structure des composés précurseurs est détruite dans le plasma à pression atmosphérique.

11. Procédé selon la revendication 9 ou 10, dans lequel les composés précurseurs ne présentent pas de liaisons C-C insaturées.

12. Procédé selon les revendications 9 à 11, dans lequel les composés précurseurs sont sélectionnés parmi les tétraalkylmonosilanes, les trialkylmonosilanes, les dialkylmonosilanes, les tétraalkoxymonosilanes, les trialcoxymonosilanes, les dialcoxymonosilanes, les tétraacyloxymonosilanes, les silazanes peralkylés et les siloxanes.

13. Procédé selon les revendications 9 à 12, dans lequel un gaz fortement oxydant, de préférence l'oxygène ou l'air, est utilisé comme gaz de procédé.

14. Structure composite qui comprend un premier et un second substrat qui sont liés l'un à l'autre par une couche de polymère plasma organosilicié, **caractérisée en ce que** la structure composite peut être obtenue avec un procédé selon la revendication 12.

15. Procédé de fabrication d'une structure composite qui comprend un premier et un second substrat qui sont liés l'un à l'autre par une couche de polymère plasma, le procédé comprenant un procédé de liaison de substrats selon les revendications 1 à 13.
